# EUROPEAN PATENT SPECIFICATION

(11) **EP 1 741 809 B1**
(45) Date of publication and mention of the grant of the patent: **13.04.2011**
(21) Application number: 05738929.8
(22) Date of filing: 27.04.2005
(51) Int. Cl.: C30B 29/30, C30B 33/02

(54) **ELECTROSTATIC CHARGE CONTROLLING PROCESS FOR PIEZOELECTRIC OXIDE SINGLE CRYSTAL**
VERFAHREN ZUR UNTERDRÜCKUNG DER ELEKTROSTATISCHEN LADUNG FÜR EINEN PIEZOELEKTRISCHEN OXID-EINKRISTALL
PROCESSUS DE CONTRÔLE DE CHARGE ÉLECTROSTATIQUE POUR LE MONOCRISTAL D"OXYDE PIÉZOÉLECTRIQUE

(30) Priority: 27.04.2004 JP 2004131733
(43) Date of publication of application: 10.01.2007
(73) Proprietor: Yamaju Ceramics Co., Ltd., Owariasahi City, Aichi 488-0012 (JP)
(72) Inventor: HOTTA, Kazutoshi, c/o YAMAJU CERAMICS CO., LTD, Seto City, Aichi 489-0003 (JP); KANNO, Kazuya, c/o YAMAJU CERAMICS CO., LTD, Seto City, Aichi 489-0003 (JP); MIYAGAWA, Daisaku, c/o YAMAJU CERAMICS CO., LTD, Seto City, Aichi 489-0003 (JP); KURACHI, Masato, c/o YAMAJU CERAMICS CO., LTD, Seto City, Aichi 489-0003 (JP); SASAMATA, Takeji, c/o YAMAJU CERAMICS CO., LTD, Seto City, Aichi 489-0003 (JP); SAHASHI, Ietaka, c/o YAMAJU CERAMICS CO., LTD, Seto City, Aichi 489-0003 (JP)
(74) Representative: TBK-Patent
(86) International application number: PCT/JP2005/008474
(87) International publication number: WO 2005/103343

(56) References cited:
- EP-A- 0 893 515
- WO-A-01/33260
- JP-A- 7 187 898
- JP-A- 2004 510 666
- JP-A- 2005 119 908
- US-A- 3 705 567
- US-A- 4 196 963

## Description

### TECHNICAL FIELD

The present invention relates to a charge restraining method for a piezoelectric oxide single crystal which is used as a piezoelectric substrate, and the like, for elastic surface acoustic wave filters, and a charge restraining apparatus therefor.

### BACKGROUND ART

A lithium tantalate (LiTaO₃) single crystal and a lithium niobate (LiNbO₃) single crystal have been known as piezoelectric oxide single crystals, and have been used in piezoelectric substrates, and the like, for elastic surface acoustic wave filters (SAW filters). Moreover, both single crystals have been also used in applied optical products, such as optical modulators and wavelength converter devices, which are basic component parts for large-capacity high-speed communication networks, as nonlinear optical crystals. Both single crystals have such characteristics that the pyroelectric coefficient is large and the resistance is high. Accordingly, electric charges are generated on their surfaces by a slight temperature change. And, once generated electric charges accumulate thereon so that the charged state continues unless carrying out de-charging from the outside.

For example, an optical modulator cause light to transmit in a light guide or the inside of single crystal directly. When modulating light, it is controlled by applying an electric field to single crystal. In this instance, even when the electric field is turned off, if an electric field remains on the surface of single crystal, light has been modulated by a remaining electric charge. Moreover, an electric charge is generated on the surface by a temperature change, and accordingly the refractive index has changed.

On the other hand, in the manufacturing steps of elastic surface acoustic wave filters, there are processes, which accompany the temperature changes of piezoelectric substrate's temperature, such as the formation of electrode thin films onto the surface of piezoelectric substrate and pre-baking and post-baking in photolithography. Accordingly, when using a lithium tantalate single crystal or a lithium niobate single crystal as a piezoelectric substrate, the generation of static electricity on piezoelectric substrate matters in the manufacturing processes of elastic surface acoustic wave filters.

When a piezoelectric substrate is charged, a static electricity discharge occurs within the piezoelectric substrate, and becomes the cause of cracks or breakage. Further, there is a fear that electrodes formed on a piezoelectric substrate might be short-circuited by static electricity. Furthermore, fine metallic powders, dust, dirt, and the like, which generates in the manufacturing steps, are attracted onto the surf ace of a piezoelectric substrate by static electricity to short-circuit its electrodes, and moreover there is a fear that the electrodes are turned into exposed states to be destroyed.

Considering such charging of piezoelectric substrates, various countermeasures are taken in manufacturing elastic surface acoustic wave filters. For example, it is possible to name disposing de-charging equipment, such as ionizers for neutralizing the electric charges on the surfaces of piezoelectric substrates, and disposing incidental equipment, such as particle counters or microscopes for measuring dust, and the like. Moreover, in the manufacturing steps of elastic surface acoustic wave filters, it has been carried out to add a conductive film forming step, in which a conductive film for the purpose of de-charging is formed on a rear surface of a piezoelectric substrate in advance, before forming electrode thin films, or a re-cleaning step after forming electrode thin films.

Moreover, in view of inhibiting lithium tantalate single crystals and lithium niobate single crystals themselves from charging, in Patent Literature No. 1, there is disclosed a method in which a wafer made from these single crystals is heat treated in a reducing atmosphere. Moreover, in Patent Literature No.2, there is disclosed a method in which a metal is diffused in the same wafer.
Patent Literature No. 1: Japanese Unexamined Patent Publication (KOKAI) No. 11-92,147 (equivalent to EP-A-0893515)
Patent Literature No. 2: Japanese Unexamined Patent Publication (KOKAI) No. 2004-35,396

US 4196963 (A) describes a process for suppressing the out-diffusion of Li2O from LiNbO3 and LiTaO3 waveguide structures by exposing the structures to a Li2O-rich environment at sufficient vapor pressure that Li2O diffuses into the structure as a compensation process and a solid-solid surface interaction occurs. In one embodiment of the invention, the out-diffusion of Li2O from LiNbO3 and LiTaO3 crystals into which Ti has been diffused is eliminated by annealing the structure in a high purity powder of LiNbO3 or LiTaO3. In a second embodiment, the Li2O out-diffusion is partially suppressed by annealing the structure in molten LiNO3. In a third embodiment of the invention, a waveguide structure comprising a Li2O-rich guiding layer is formed by annealing LiNbO3 or LiTaO3 crystals in a high purity powder of LiNbO3 or LiTaO3, which not only suppresses Li2O out-diffusion but also promotes Li2O in-diffusion into the crystals.

### DISCLOSURE OF THE INVENTION

For example, the Curie point of lithium tantalate single crystal is about 603 °C. Accordingly, when the lithium tantalate single crystal is exposed to high temperatures of more than 600 °C, there is a fear of losing its piezoelectricity. That is, when considering the piezoelectricity of lithium tantalate single crystal, it is not possible to carry out heat treating at a high temperature. On the other hand, even when a wafer made from a lithium tantalate single crystal is heat treated at a relatively low temperature of from 400 to 600 °C approximately, nothing but only the surface of the wafer is reduced. That is, by the heat treatment in a reducing gas set forth in above Patent Literature No. 1, it is difficult to inhibit charging without impairing the piezoelectricity of lithium tantalate single crystal.

Moreover, as set forth in Patent Literature No. 2, when diffusing a metal, such as zinc, in a single crystal, the mixing of the other elements changes the Curie point so that the piezoelectricity has changed. In addition, since the metal deposits on the wafer, it is needed to remove the deposits after the treatment. Furthermore, when employing a metal with violent reactivity, it becomes impossible to adjust the reduction degree.

The present invention has been performed in view of such circumstances, and it is an assignment to provide a processing method which can restrain the charging of lithium tantalate single crystal or lithium niobate single crystal. In addition, it is an assignment to provide a processing apparatus which can carry out the processing method simply and easily.

Means for Solving the Assignments

A method for charge restraining a piezoelectric oxide single crystal according to the present invention is characterized in that it comprises: accommodating a wafer, made from a lithium tantalate single crystal or a lithium niobate single crystal, and a reducing agent, including an alkali metal compound, in a processing apparatus; and reducing the wafer by holding the inside of the processing apparatus at a temperature of from 200 °C to 1000 °C under decompression of from 133 × 10⁻¹ to 133 × 10⁻⁷ Pa.

In the present method for charge restraining, a wafer, made from a lithium tantalate single crystal or a lithium niobate single crystal, is heated to and held at a predetermined temperature under decompression, together with a reducing agent. An alkali metal compound, constituting the reducing agent, evaporates under a predetermined condition, and turns into a vapor with high reducing power. When being exposed to this vapor, the wafer is reduced sequentially from the surface. And, by keeping supplying the reducing agent, it is possible to continuously develop the reducing reaction, and accordingly it is possible to uniformly reduce the entire wafer. Moreover, in accordance with the present charge restraining method, the productivity improves because the processing time can be reduced to 1/10 or less than conventionally.

The resistance of the wafer is decreased by reduction. Accordingly, the reduced wafer is less likely to produce electric charges even when the temperature changes. Moreover, even if electric charges generate on the wafer's surface tentatively, they self-neutralize quickly, and consequently it is possible to remove the electric charges. Thus, in accordance with the present charge restraining method, it is possible to effectively inhibit the wafer, made from an LT single crystal or an LN single crystal, from charging.

In the present charge restraining method, an alkali metal compound whose reaction is relatively gentle is used as the reducing agent. Accordingly, it is easy to handle the reducing agent, and the safety is high. Moreover, by adequately adjusting the type of reducing agent, the usage amount, the disposing form, the vacuum degree within a processing tank, the temperature and the processing time, it is possible to control the reduction degree of the wafer.

Since the wafer processed by the present charge restraining method is less likely to be charged, it can be handled with ease and is safe. Moreover, when manufacturing an elastic surface acoustic wave filter using the same wafer as a piezoelectric substrate, it becomes unnecessary to dispose de-charging equipment so that the cost can be reduced remarkably. In addition, since a manufacturing process for de-charging becomes unnecessary as well, the productivity improves. Moreover, by making a piezoelectric substrate from the same wafer, it is possible to constitute an elastic surface acoustic wave filter, which causes defects resulting from static electricity less, in storage as well as in service. In addition, when employing the same wafer as applied optical products, such as optical modulators and wavelength converter devices, the modulations resulting from residual electric charges, and the refractive index changes resulting from the generation of electric charges are inhibited. Accordingly, the reliability of applied optical products improves.

In the present charge restraining method,when making a wafer from a lithium tantalate single crystal, the reduction of the wafer can desirably be carried out at a temperature of from 200 °C to 600 °C.

As described above, when the lithium tantalate single crystal is exposed to high temperatures of above 600 °C, there is a fear of losing its piezoelectricity. Therefore, when a wafer made from a lithium tantalate single crystal is reduced, it can desirably be treated at relatively low temperatures of 600 °C orless. In the present charge restraining method,because of employing an alkali metal compound with high reducibility,whole wafer can be reduced sufficiently even at a temperature of 600 °C or less. Thus, by carrying out a reduction treatment at relatively low temperatures,it is possible to restrain the charging of lithium tantalate single crystal or lithium niobate single crystal without impairing the piezoelectricity.

In the present charge restraining method, the reduction of the wafer is carried out under decompression of from 133 X 10⁻¹ to 133 X 10⁻⁷ Pa. By raising the degree of vacuum in a processing tank, it is possible to turn an alkali metal compound into a vapor with high reducing power even at relatively low temperatures.

The oxygen in an LT single crystal or an LN single crystal exhibits a high bonding force with lithium. Accordingly, in the reduction treatments, the oxygen is likely to be emitted in a state being bonded with lithium, that is, in a state of lithium oxide. As a result, the lithium concentration in the single crystals decreases to change the lithium:tantalum (niobium) ratio so that there is a fear of changing the piezoelectricity.

Therefore, an alkali metal compound used as the reducing agent can desirably be made into lithium compound. Thus, it is possible to react the oxygen in the single crystals with lithium atoms supplied from the reducing agent. Accordingly, the lithium atoms in the single crystals are less likely to be emitted. Consequently, the lithium:tantalum (niobium) ratio does not change so that the piezoelectricity does not decrease. Moreover, since lithium is a constituent element of the single crystals, there are no worries about the pollution resulting from the mixing of the other elements.

In the present charge restraining method, it is possible to employ an embodiment in which the reducing agent comprising an alkali metal compound is used; and the reduction of the wafer is carried out by disposing the reducing agent and the wafer separately, or by burying the wafer in the reducing agent. In the present embodiment, it is possible to use powders, pellets and the like of alkali metal compounds as the reducing agent. Since it is possible to use powders, pellets and the like of alkali metal compounds as they are, the present embodiment can be carried out with ease. Moreover, when burying the wafer in the reducing agent, the reducing agent contacts with the surfaces of the wafer with a high concentration. Accordingly, it is possible to furthermore facilitate the reduction of the wafer.

Moreover, when employing an alkalimetal compound solution, in which the alkali metal compound is dissolved or dispersed in a solvent, is used as the reducing agent, it is possible to employ an embodiment in which the reduction of the wafer is carried out by disposing the reducing agent and the wafer separately, or by immersing the wafer into the reducing agent, or by painting the reducing agent onto a surface of the wafer.

In the present embodiment, an alkali metal compound solution is used as the reducing agent. For example, an alkali metal compound solution, in which an alkali metal compound is dissolved or dispersed in an organic solvent, generates an organic gas when being heated. By filling up a vapor of an alkali metal compound into this organic gas, it is possible to enhance the reactivity between the alkali metal and the wafer. Thus, the entire wafer is reduced evenly. Moreover, when immersing the wafer into the same solution, or when painting the same solution onto a surface of the wafer, the reducing agent contacts with the surface of the wafer with a high concentration. Accordingly, it is possible to furthermore facilitate the reduction of the wafer.

In the present charge restraining method, the wafer is reduced under predetermined conditions, using the reducing agent. Since the entire wafer can be reduced sufficiently, it is possible to effectively inhibit the wafer from charging. Moreover, by adequately adjusting the reducing agent, the processing conditions, and the like, it is possible to control the reduction degree of the wafer.

### BRIEF DESCRIPTION OF THE DRAWINGS

Fig. 1 is a schematic diagram of a charge restraining apparatus, a first embodiment according to the present invention.

Fig. 2 is a model diagram for illustrating how wafers are disposed in a processing tank (first embodiment).

Fig. 3 is a model diagram for illustrating how wafers and a reducing agent are disposed in a processing tank (second embodiment).

Fig. 4 is a graph for illustrating a relationship between processing temperature and bulk resistivity (Example Nos. 11 through 15).

Fig. 5 is a graph for illustrating a relationship between processing temperature and bulk resistivity (Example Nos. 16 and 17).

Fig. 6 is a graph for illustrating a relationship between processing pressure and bulk resistivity (Example Nos. 21 through 22).

Fig. 7 is a graph for illustrating a relationship between processing time and bulk resistivity (Example Nos. 31 through 34).

Description of the sign
1: a charge restraining apparatus
2: a processing tank
3: a heater (means for heating)
4: a vacuum pump (means for decompressing)
50: wafers 51: a wafer cassette case 52: a tank
60: a lithium chloride powder (a reducing agent) 61: a petri dish
62: a lithium carbonate solution (a reducing agent)

### BEST MODE FOR CARRYING OUT THE INVENTION

Hereinafter, embodiments of the charge restraining method according to the present invention will be described in detail, while describing embodiments of the used charge restraining apparatus simultaneously.

### (1) First Embodiment

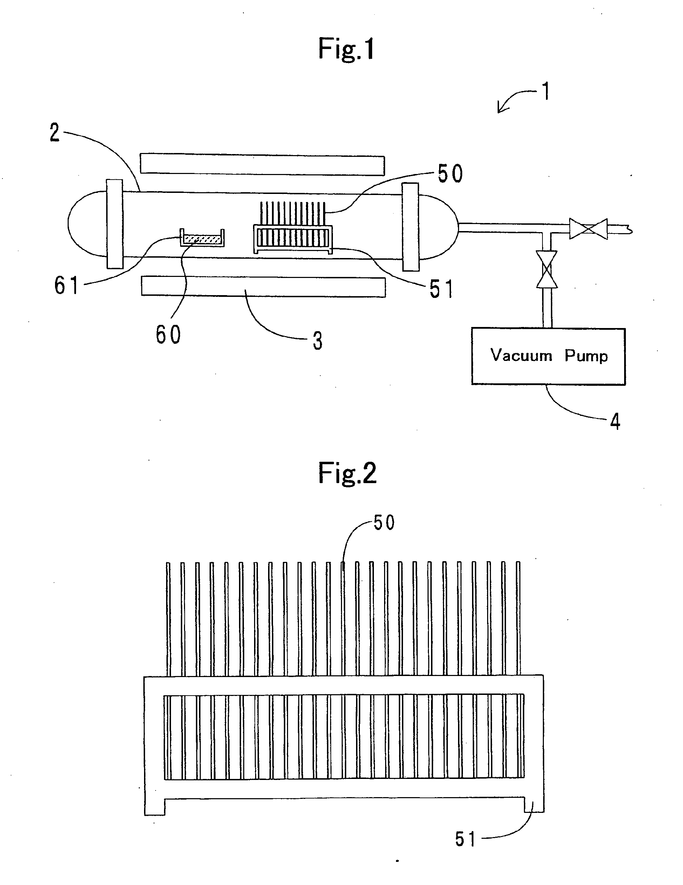

First, an arrangement of a charge restraining apparatus, the present embodiment, will be described. In Fig. 1, an outline of the charge restraining apparatus is illustrated. Moreover, in Fig. 2, how wafers are disposed in a processing tank is illustrated with a model. As illustrated in Fig. 1, a charge restraining apparatus 1 comprises a processing tank 2, a heater 3, and a vacuum pump 4.

The processing tank 2 is made of quartz glass. One of the opposite ends of the processing tank 2 is connected with piping. Through the connected piping, the evacuation within the processing tank 2 is carried out. In the processing tank 2, wafers 50 and a lithium chloride powder 60 are accommodated.

The wafers 50 are supported by a wafer cassette case 51 made of quarts. The wafers 50 are composed of 42° Y-Xcut LT single crystal. The diameter of the wafers 50 is 4 inches (about 10.16 cm), and the thickness is 0.5 mm. The wafers 50 are disposed in a quantity of 50 pieces at intervals of about 5 mm.

The lithium chloride powder 60 is disposed, independently of the wafers 50, within a petri dish 61 made of quartz glass. The lithium chloride powder 60 is the reducing agent in the present invention. The amount of lithium chloride powder 60 to be accommodated is 100 g.

The heater 3 is disposed so as to cover around the processing tank 2. The heater 3 is included in the heating means constituting the present charge restraining apparatus.

The vacuum pump 4 is connected with the processing tank 2 by way of the piping. The vacuum pump 4 evacuates gases within the processing tank 2 to vacuumize the inside of the processing tank 2. The vacuum pump 4 is included in the decompressing means constituting the present charge restraining apparatus.

Next, an example flow of a charge restraining treatment by the charge restraining apparatus of the present embodiment will be described. First, by the vacuum pump 4, the inside of the processing tank 2 is turned into a vacuum atmosphere of 1.33 Pa approximately. Next, by the heater 3, the processing tank 2 is heated to raise the temperature within the processing tank 2 to 550 °C for 3 hours. When the temperature within the processing tank 2 reaches 550 °C, it is held in the state for 18 hours. Thereafter, the heater 3 is turned off to naturally cool the inside of the processing tank 2.

In accordance with the present embodiment, the following advantages set forth below can be obtained. That is, in the present embodiment, the lithium chloride powder 60 was used as the reducing agent. Accordingly, it is possible to react the oxygen in the LT single crystal with the lithium atoms with are supplied from the reducing agent. Consequently, the lithium atoms in the LT single crystal are less likely to be released. Therefore, the lithium: tantalum ratio in the LT single crystal does not change so that the piezoelectricity does not decrease. Moreover, since lithium is a constituent component of the LT single crystal, there is no fear of contamination resulting from the mixing other elements. In addition, the lithium chloride powder 60 is easy to handle so that it is possible to carry out the charge restraining treatment safely.

In the present embodiment, the lithium chloride powder 60 was used in an amount of 100 g. According to a preparatory experiment, the amount of lithium chloride powder consumed under the aforementioned processing conditions (550 °C and 18 hours) is about 40 g. Accordingly, in the present embodiment, it is possible to continuously develop the reduction reaction so that it is possible to uniformly reduce the entire wafers 50. As a result, it is possible to effectively restrain the charging of wafers 50.

In the present embodiment, since the inside of the processing tank 2 is turned into a vacuum atmosphere of 1.33 Pa approximately, the lithium chloride powder 60 is turned into a vapor with high reducing power. Accordingly, it is possible to carry out a reduction treatment at 550 °C so that it is possible to carry out the reduction of the entire wafers 50 without impairing the piezoelectricity.

### (2) Second Embodiment

The difference between a second embodiment and the first embodiment is that the type of the reducing agent and the disposing form were altered. Since the other arrangements are identical with those of the first embodiment, the differences will be described herein.

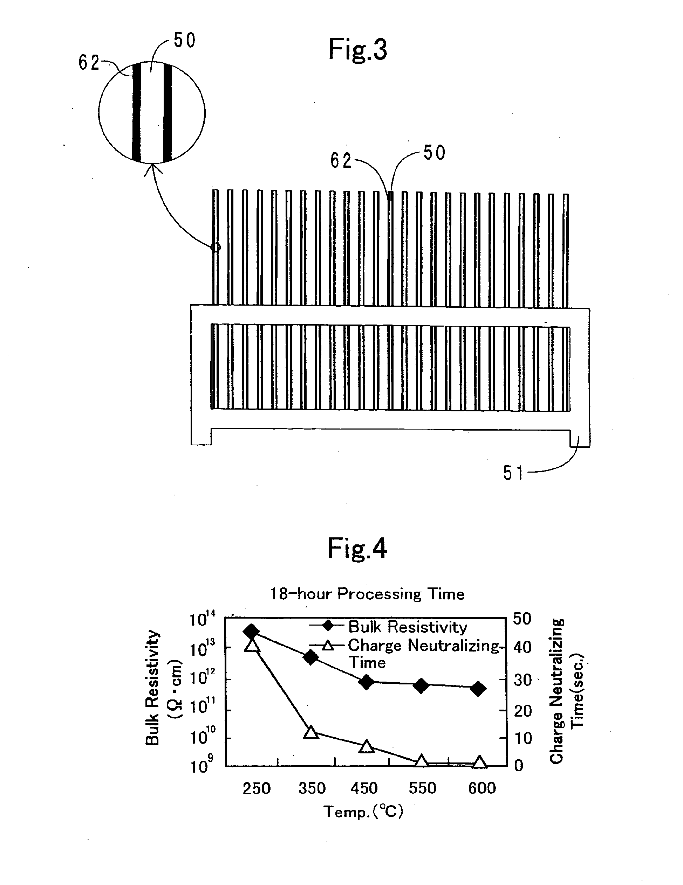

In Fig. 3, how wafers and a reducing agent are disposed in the present embodiment is illustrated with a model. In Fig. 3, component parts corresponding to those in Fig. 2 are designated with the same reference numerals. As illustrated in Fig. 3, the both opposite surfaces of wafers 50 are coated with a lithium carbonate solution 62 in which 100 g lithium carbonate powder is dissolved into polyvinyl alcohol. The lithium carbonate solution 62 is the reducing agent in the present invention. The coating of the wafers 50 was carried out by immersing the wafers 50 into the lithium carbonate solution 62, painting the lithium carbonate solution 62 onto the surfaces of wafers 50, and thereafter drying them at room temperature and 200 °C. Within a processing tank 2, only a wafer cassette case 51, which holds the wafers 50 therein, is disposed. And, a charge restraining treatment is carried out in the same manner as the first embodiment.

In accordance with the present embodiment, the following advantages set forth below can be obtained, in addition to the operations and advantages described in the first embodiment. That is, in the present embodiment, the lithium carbonate solution 62 was used as the reducing agent. The lithium carbonate solution 62 generates organic gases, upon being heated. By filling up the vapor of lithium carbonate into the organic gases, the reduction of wafers 50 is facilitated. Additionally, since the lithium carbonate solution 62 is disposed to contact with the surfaces of wafers 50, the reduction of wafers 50 are furthermore facilitated.

### (3) Other Embodiments

So far, a few embodiments of the charge restraining apparatus according to the present invention have been described. However, embodiments of the present charge restraining apparatus are not limited to the aforementioned embodiments, but can be carried out in various forms subjected to various changes and modifications based on the knowledge of one of ordinary skill in the art.

For example, in the aforementioned embodiments, the charge restraining treatments are carried out onto the wafers made from an LT single crystal. However, wafers made from an LN single crystal can be processed, moreover, wafers made from the respective single crystals can be processed simultaneously. In addition, wafers made from an LT single crystal or LN single crystal with a metal, such as iron, added, can be processed. In this instance, as for the additive metal, it is possible to name iron, copper, manganese, molybdenum, cobalt, nickel, zinc, carbon, magnesium, titanium, tungsten, indium, tin, rare-earth elements, and the like. Moreover, the addition amount can be from 0.01% by weight or more to 1.00% by weight or less when the entire weight of single crystal is taken as 100% by weight. An LT crystal and so on with a metal, such as iron, added has a charge neutralizing characteristic for self-neutralizing surface charges and removing them. By reducing wafers made from such a single crystal, it is possible to more effectively inhibit the charging of wafers. Note that the shapes, polished states and so forth of using wafers are not limited in particular. For instance, it is advisable to use as-cut crystal blocks which are cut out of a single crystal to a predetermined thickness, moreover, it is possible to use such crystal blocks whose surfaces are mirror polished.

The types of alkali metal compound constituting the reducing agent are not limited to the aforementioned embodiments. For example, in the case of lithium compound, it is possible to use lithium hydroxide, and the like, in addition to the lithium chloride and lithium carbonate used in the aforementioned embodiments. Moreover, it is advisable to use alkali metal compounds other than the lithium compounds, specifically, sodium compounds, such as sodium carbonate and sodium hydroxide, potassium compounds, such as potassium carbonate, potassium hydroxide and potassium chloride. It is advisable to use each of these alkali metal compounds independently, or it is advisable to use two or more of them combinedly.

In the first embodiment, the reducing agent and the wafers are disposed separately, however, the charge restraining treatment can be carried out while burying the wafers in the reducing agent. Moreover, it is advisable to use a gas including an alkali metal compound as the reducing agent. In this instance, it is advisable to carry out the charge restraining treatment while introducing a gas including an alkali metal compound into a processing tank held under a predetermined condition. Alternatively, it is advisable to carry out the charge restraining treatment while supplying a gas including an alkali metal compound into a processing tank and evacuating it therefrom continuously.

When an alkali metal compound solution is used as the reducing agent like the second embodiment, it is desirable to use a liquid, which does not generate oxygen in vacuum atmospheres, as the solvent. For example, in addition to the aforementioned polyvinyl alcohol, organic solvents, such as glycerin which is readily available, are suitable. Moreover, when using an alkali metal compound solution as the reducing agent, it is advisable to make the concentration of alkali metal compound as high as possible, in view of furthermore promoting the reduction of wafers. In addition, when using an alkali metal compound solution, it is advisable to accommodate the same solution in a container and dispose it independently of wafers, or it is advisable to immerse wafers into the same solution.

In the aforementioned embodiments, the treatments were carried out in a vacuum atmosphere of 1. 33 Pa approximately. However, the processing pressure is not limited in particular. The processing at pressures lower than 1.33 Pa, that is, under higher vacuum atmospheres, is suitable.

Moreover, the processing time is not limited in particular, but can be determined appropriately while taking the processing temperature, and the like, into consideration. By thus adjusting the type of reducing agent, the using amount, the disposing form, the vacuum degree within processing tank, the temperature and the processing time, it is possible to control the reduction degree of wafers.

### EXPERIMENTAL EXAMPLES

(1) Charge Restraining Treatment by First Embodiment

By using the charge restraining apparatus according to the aforementioned first embodiment, various charge restraining treatments were carried out under the conditions set forth in Table 1 and Table 2 below. The charge restraining treatments were carried out in compliance with the flow of the charge restraining treatment according to the first embodiment. As set forth in Table 1, the charge restraining treatments, which were carried out at a processing pressure of 8.38 × 10⁻¹ Pa for 18-hour processing time but whose processing temperatures were varied, were labeled Example Nos. 11 through 15. Moreover, the charge restraining treatments, which were carried out at the same processing pressure for 6-hour processing time but whose processing temperatures were varied, were labeled Example Nos. 16 and 17. As set forth in Table 2, the charge restraining treatments, which were carried out at a processing temperature of 550 °C for 18-hour processing time but whose processing pressures were varied, were labeled Example Nos. 21 through 25. Note that, for comparison, charge restraining treatments, which were carried out without using the reducing agent, were labeled Comparative Example Nos. 11 through 15 and 21 through 23, depending on the respective conditions.

**TABLE 1**

| Reducing Agent | Processing Time (hour) | Processing Temp. (°C) | | | | |
|---|---|---|---|---|---|---|
| | | 250 | 350 | 450 | 550 | 600 |
| Lithium Chloride Powder | 18 | Ex. #11 | Ex. #12 | Ex. #13 | Ex. #14 | Ex. #15 |
| None | 18 | | | Comp. Ex. #11 | Comp. Ex. #12 | Comp. Ex. #13 |
| Lithium Chloride Powder | 6 | | | Ex. #16 | Ex. #17 | |
| None | 6 | | | Comp. Ex. #14 | Comp. Ex. #15 | |

| | | | | | | |
|---|---|---|---|---|---|---|
| *Processing Pressure: 8.38 × 10⁻¹ Pa | | | | | | |

**TABLE 2**

| Reducing Agent | Processing Pressure (Pa) | | | | |
|---|---|---|---|---|---|
| | 133 × 10⁻¹ | 133 × 10⁻² | 133 × 10⁻³ | 133 × 10⁻⁶ | 133 × 10⁻⁷ |
| Lithium Chloride Powder | Ex. #21 | Ex. #22 | Ex. #23 | Ex. #24 | Ex. #25 |
| None | | | Comp. Ex. #21 | Comp. Ex. #22 | Comp. Ex. #23 |

| | | | | | |
|---|---|---|---|---|---|
| *Processing Temp.: 550 °C, Processing Time: 18 hours | | | | | |

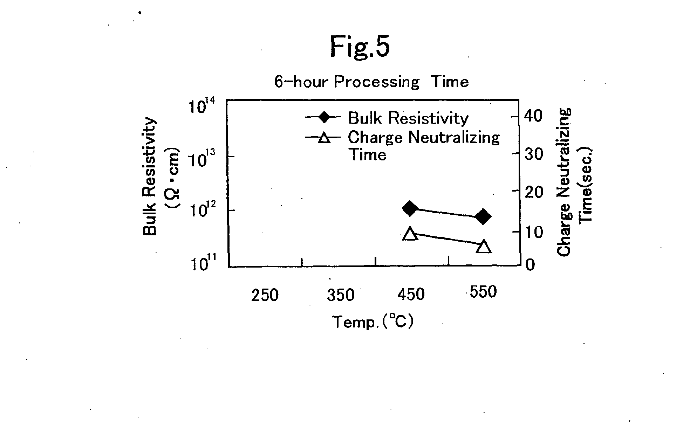

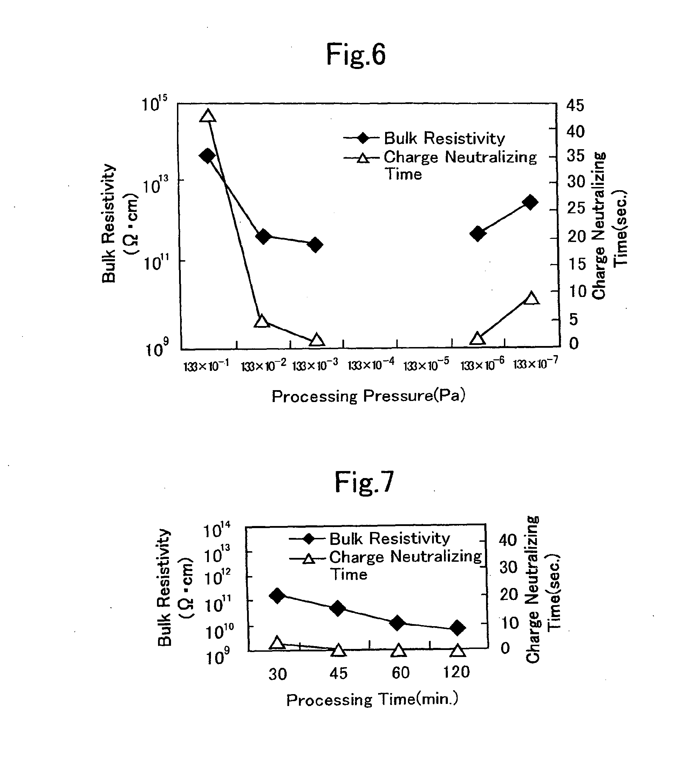

Regarding the respective wafers which were charge restrained, the bulk resistivity, and the transmissivity were measured. The bulk resistivity was measured using "DSM-8103" made by TOA DKK Co., Ltd. The transmissivity was measured using an ultraviolet-visible light spectrophotometer ("V570" made by NIHON BUNKOU Co., Ltd.). Moreover, the wafers were placed on a plate which was set up at 80 ±5 °C, and the subsequent changes of surface voltage with time were measured. And, the times (charge neutralizing times) required for surface voltage to be 0 kv were measured. In Table 3 and Table 4, there are set forth the measurement results on the wafers, which were subjected to the respective charge restraining treatments according to examples and comparative examples, and on unprocessed wafers. Note that the surface voltages in Tables 3 and 4 are values immediately after the wafers were placed on the 80±5 °C plate. Moreover, in Fig. 4, there are illustrated relationships between the processing temperature and the bulk resistivity as well as the charge neutralizing time (18-hour processing time; Example Nos. 11 through 15). In Fig. 5, there are illustrated relationships between the processing temperature and the bulk resistivity as well as the charge neutralizing time (6-hour processing time; Example Nos. 16 and 17). In Fig. 6, there are illustrated relationships between the processing pressure and the bulk resistivity as well as the charge neutralizing time (Example Nos. 21 through 25).

**TABLE 3**

| | Ex. #11 | Ex. #12 | Ex. #13 | Ex. #14 | Ex. #15 | Comp. Ex. #11 | Comp. Ex. #12 | Comp. Ex. #13 |
|---|---|---|---|---|---|---|---|---|
| Bulk Resistivity (Ω·cm) | 3.8 × 10¹³ | 4.9 × 10¹² | 7.3 × 10¹¹ | 5.2 × 10¹¹ | 3.9 × 10¹¹ | 3.3 × 10¹⁴ | 2.3 × 10¹³ | 2.6 × 10¹³ |
| Surface Voltage (kV) | 3.83 | 1.12 | 0.52 | 0.20 | 0.15 | 4.14 | 2.41 | 2.36 |
| Charge Neutralizing Time (sec.) | 42 | 11.7 | 6.8 | 1.0 | 0.5 | ∞ | 45 | 46 |

| | Ex. #16 | Ex. #17 | Comp. Ex. #14 | Comp. Ex. #15 | Unprocessed | | | |
|---|---|---|---|---|---|---|---|---|
| Bulk Resistivity (Ω·cm) | 9.8 × 10¹¹ | 6.9 × 10¹¹ | 6.1 × 10¹⁹ | 8.9 × 10¹³ | 2.3 × 10¹⁵ | | | |
| Surface Voltage (kV) | 0.79 | 0.30 | 4.43 | 3.95 | 4.31 | | | |
| Charge Neutralizing Time (sec.) | 8.4 | 5.0 | ∞ | ∞ | ∞ | | | |

**TABLE 4**

| | Ex. #21 | Ex. #22 | Ex. #23 | Ex. #24 | Ex. #25 | Comp. Ex. #21 | Comp. Ex. #22 | Comp. Ex. #23 |
|---|---|---|---|---|---|---|---|---|
| Bulk Resistivity (Ω·cm) | 3.8 × 10¹⁴ | 4.5 × 10¹¹ | 3. 3 × 10¹¹ | 5.2 × 10¹¹ | 3. 5 × 10¹¹ | 3. 3 × 10¹³ | 2. 3 × 10¹³ | 2. 6 × 10¹⁴ |
| Surface Voltage (kV) | 4.1 | 0.41 | 0.16 | 0.20 | 0.7 | 2.34 | 1.5 | - |
| Charge Neutralizing Time (sec.) | ∞ | 4.2 | 0.9 | 1.0 | 8.7 | 45 | 19.7 | - |

As set forth in Table 3, when comparing the wafers according to the examples with the wafers according to the comparative examples, wafers which were processed at the same temperature, the bulk resistivity and surface voltage were lowered and the charge neutralizing time was shortened in all of the wafers according to the examples. Moreover, it was confirmed that the transmissivity was also lowered. Thus, it is understood that the wafers were reduced efficiently by the reducing agent so that the charging was restrained. Moreover, as shown in Fig. 4 and Fig. 5, the higher the processing temperature was, the more the bulk resistivity of wafers was lowered and the more the charge neutralizing time was shorted. Similarly, the transmissivity and surface voltage were lowered as well. In addition, when comparing the processing times alone, the charge restraining effect was enhanced more for those which were processed for 18 hours. Thus, in accordance with the charge restraining treatment of the present invention, it was confirmed possible to effectively inhibit the charging of wafers. Additionally, by adjusting the processing temperature or processing time, it was confirmed possible to control the reduction degree. Moreover, in a range of from 250 °C to 600 °C, it was understood that the higher the processing temperature is the larger the reduction degree is so that the charge restraining effect is produced greatly.

As set forth in Table 4, when comparing the wafers according to the examples with the wafers according to the comparative examples, wafers which were processed at the same pressure, the bulk resistivity and surface voltage were lowered and the charge neutralizing time was shortened in all of the wafers according to the examples. Moreover, it was confirmed that the transmissivity was also lowered. Thus, as mentioned above, it is understood that the wafers were reduced efficiently by the reducing agent so that the charging was restrained. Moreover, as shown in Fig. 6, the bulk resistivity of wafers were lowered and particularly the reduction of charge neutralizing time was remarkable when the processing pressure was lowered from 133 × 10⁻¹ to 133 × 10⁻² Pa. The transmissivity and surface voltage were also lowered similarly. Note that, at 133 × 10⁻⁷ Pa, the bulk resistivity and the like rose slightly. Thus, in the charge restraining treatment of the present invention, it is possible to control the reduction degree by adjusting the processing pressure. In the present embodiment, it is possible to say that a processing pressure of from 133 × 10⁻² to 133 × 10⁻⁶ Pa is suitable.

(2) Charge Restraining Treatment by Second Embodiment

By using the charge restraining apparatus according to the aforementioned second embodiment, charge restraining treatments were carried out under the conditions set forth in Table 5 below. That is, charge restraining treatments, which were carried out at a processing temperature of 550 °C under a processing pressure of 10.5 × 10⁻¹ Pa but whose processing times were varied, were labeled Example Nos. 31 through 34.

**TABLE 5**

| Reducing Agent | Processing Time (min.) | | | |
|---|---|---|---|---|
| | 30 | 45 | 60 | 120 |
| Lithium Carbonate Solution | Ex. #31 | Ex. #32 | Ex. #33 | Ex. #34 |

| | | | | |
|---|---|---|---|---|
| *Processing Temp.: 550 °C, Processing Pressure: 10.5 × 10⁻¹ Pa | | | | |

Regarding the respective wafers which were charge restrained, the bulk resistivity, the transmissivity, the changes of surface voltage with time, and the charge neutralizing time were measured in the same manner as above (1). In Table 6, there are set forth the measurement results on the wafers, which were subjected to the respective charge restraining treatments according to Example Nos. 31 through 34. Moreover, in Fig. 7, there are illustrated relationships between the processing time and the bulk resistivity as well as the charge neutralizing time.

**TABLE 6**

| | Ex. #31 | Ex. #32 | Ex. #33 | Ex. #34 |
|---|---|---|---|---|
| Bulk Resistivity (Ω .cm) | 1.8 × 10¹¹ | 4 . 5 × 10¹⁰ | 1. 3 × 10¹⁰ | 8.2 × 10⁹ |
| Surface Voltage (kV) | 0.06 | 0.04 | < 0.02 | < 0.01 |
| Charge Neutralizing Time (sec.) | 2.1 | 0.7 | < 0.1 | < 0.1 |

As represented in Table 6 and Fig. 7, the longer the processing time was, the more the bulk resistivity and surface voltage of wafers were lowered and the more the charge neutralizing time was shorted. Moreover, it was confirmed that the transmissivity was also lowered. Thus, in the charge restraining treatment of the present invention, it is possible to control the reduction degree by adjusting the processing time. In the present embodiment, when the processing time is adapted to be 60 minutes or more, it is understood that the charge restraining effect is produced greatly.

## Claims

1. A method for charge restraining a piezoelectric oxide single crystal, being **characterized in that** it comprises:
accommodating a wafer, made from a lithium tantalate single crystal or a lithium niobate single crystal, and a reducing agent, including an alkali metal compound, in a processing apparatus; and
reducing the wafer by holding the inside of the processing apparatus at a temperature of from 200 °C to 1000°C under decompression of from 133 x 10⁻¹ to 133 x 10⁻⁷ Pa.

2. The method for charge restraining a piezoelectric oxide single crystal set forth in claim 1, wherein the wafer is made from a lithium tantalate single crystal; and the reduction of the wafer is carried out at a temperature of from 200°C to 600°C.

3. The method for charge restraining a piezoelectric oxide single crystal set forth in claim 1, wherein the alkali metal compound is a lithium compound.

4. The method for charge restraining a piezoelectric oxide single crystal set forth in claim 1, wherein the reducing agent comprises the alkali metal compound; and the reduction of the wafer is carried out by disposing the reducing agent and the wafer separately, or by burying the wafer in the reducing agent.

5. The method for charge restraining a piezoelectric oxide single crystal set forth in claim 1, wherein the reducing agent is an alkali metal compound solution in which the alkali metal compound is dissolved or dispersed in a solvent; and
the reduction of the wafer is carried out by disposing the reducing agent and the wafer separately, or by immersing the wafer into the reducing agent, or by painting the reducing agent onto a surface of the wafer.

## Patentansprüche

1. Verfahren zur Ladungshemmung eines piezoelektrischen Oxid-Einkristalls, das **dadurch gekennzeichnet ist, dass** es umfasst:
Unterbringen eines Wafers, der aus einem Lithiumtantalat-Einkristall oder einem Lithiumniobat-Einkristall hergestellt ist, und eines Reduktionsmittels, das eine Alkalimetallverbindung beinhaltet, in einer Verarbeitungsvorrichtung; und
Reduzieren des Wafers durch Halten des Inneren der Verarbeitungsvorrichtung bei einer Temperatur von 200°C bis 1000°C unter Dekompression von 133 x 10⁻¹ bis 133 x 10⁻⁷ Pa.

2. Verfahren zur Ladungshemmung eines piezoelektrischen Oxid-Einkristalls nach Anspruch 1, wobei der Wafer aus einem Lithiumtantalat-Einkristall hergestellt ist; und die Reduktion des Wafers bei einer Temperatur von 200°C bis 600°C ausgeführt wird.

3. Verfahren zur Ladungshemmung eines piezoelektrischen Oxid-Einkristalls nach Anspruch 1, wobei die Alkalimetallverbindung eine Lithiumverbindung ist.

4. Verfahren zur Ladungshemmung eines piezoelektrischen Oxid-Einkristalls nach Anspruch 1, wobei das Reduktionsmittel die Alkalimetallverbindung umfasst; und die Reduktion des Wafers durch getrenntes Anordnen des Reduktionsmittels und des Wafers oder Einbringen des Wafers in das Reduktionsmittel ausgeführt wird.

5. Verfahren zur Ladungshemmung eines piezoelektrischen Oxid-Einkristalls nach Anspruch 1, wobei das Reduktionsmittel eine Alkalimetallverbindungslösung ist, in welcher die Alkalimetallverbindung in einem Lösungsmittel gelöst oder dispergiert ist; und
die Reduktion des Wafers durch getrenntes Anordnen des Reduktionsmittels und des Wafers, oder durch Eintauchen des Wafers in das Reduktionsmittel, oder durch Lackieren des Reduktionsmittels auf die Oberfläche des Wafers ausgeführt wird.

## Revendications

1. Procédé destiné à limiter la charge d'un monocristal d'oxyde piézoélectrique, qui est **caractérisé en ce qu'**il comprend le fait :
de recevoir une plaquette, réalisée en un monocristal de tantalate de lithium ou en un monocristal de niobate de lithium, et un agent de réduction, comportant un composé métallique alcalin, dans un appareil de traitement ; et
de réduire la plaquette en maintenant l'intérieur de l'appareil de traitement à une température allant de 200°C à 1000°C sous une décompression allant de 133 x 10-1 à 133 x à 10-7 Pa.

2. Procédé destiné à limiter la charge d'un monocristal d'oxyde piézoélectrique selon la revendication 1, dans lequel la plaquette est réalisée en un monocristal de tantalate de lithium ; et la réduction de la plaquette est exécutée à une température allant de 200°C à 600°C.

3. Procédé destiné à limiter la charge d'un monocristal d'oxyde piézoélectrique selon la revendication 1, dans lequel le composé métallique alcalin est un composé de lithium.

4. Procédé destiné à limiter la charge d'un monocristal d'oxyde piézoélectrique selon la revendication 1, dans lequel l'agent de réduction comprend le composé métallique alcalin ; et la réduction de la plaquette est exécutée par la disposition de l'agent de réduction et de la plaquette séparément, ou par l'enfouissement de l'agent de réduction dans la plaquette.

5. Procédé destiné à limiter la charge d'un monocristal d'oxyde piézoélectrique selon la revendication 1, dans lequel l'agent de réduction est une solution de composé métallique alcalin dans laquelle le composé métallique alcalin est dissous ou dispersé dans un solvant ; et
la réduction de la plaquette est mise en oeuvre en disposant l'agent de réduction et la plaquette séparément, ou en immergeant la plaquette dans l'agent de réduction, ou en peignant l'agent de réduction sur une surface de la plaquette.
